# EUROPEAN PATENT APPLICATION

(11) **EP 3 950 870 A1**
(43) Date of publication of application: **09.02.2022**
(21) Application number: 20784179.2
(22) Date of filing: 09.03.2020
(51) Int. Cl.: C09J 9/02, C09J 11/04, H04R 17/00

(54) **ULTRASONIC TRANSCEIVER**

(30) Priority: 29.03.2019 JP 2019065594
(71) Applicant: Panasonic Intellectual Property Management Co., Ltd., Osaka-shi, Osaka 540-6207 (JP)
(72) Inventor: ISHIZAKI Yudai, Osaka-shi, Osaka 540-6207 (JP); NAGAHARA Hidetomo, Osaka-shi, Osaka 540-6207 (JP)
(74) Representative: SSM Sandmair
(86) International application number: PCT/JP2020/010042
(87) International publication number: WO 2020/203072

(57) **Abstract**

An ultrasonic transceiver includes a case (3) having conductivity, a piezoelectric body (1) having a piezoelectric electrode (2b), and an adhesive member (4) that bonds the case (3) to the piezoelectric body (1). The adhesive member (4) includes an adhesive (6) and conductive particles (5), and secures electrical continuity between the case (3) and the piezoelectric electrode. An adhesive layer formed of the adhesive member (4) provided between the case (3) and the piezoelectric electrode (2b) has a thickness equal to or less than a particle diameter of the conductive particles (5). With this configuration, the ultrasonic transceiver can secure electrical continuity even when a proportion of the conductive particles (5) in the adhesive layer is small, secure a predetermined adhesive strength by increasing a proportion of the adhesive (6), and stabilize a thickness of the adhesive layer by the conductive particles (5) serving as spacers.

## Description

### TECHNICAL FIELD

The present disclosure relates to an ultrasonic transceiver that transmits and receives ultrasonic waves using a piezoelectric body.

### BACKGROUND ART

Conventionally, in this type of ultrasonic transceivers, a piezoelectric body and a case are bonded with a non-conductive adhesive in order to secure adhesive strength (for example, PTL 1).

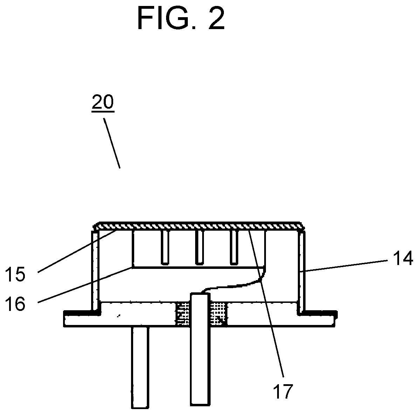

FIG. 2 illustrates a conventional ultrasonic transceiver. As illustrated in FIG. 2, conventional ultrasonic transceiver 20 includes metal case 14, piezoelectric body 16, and adhesive 17 that connects piezoelectric body 16 and case top inner wall 15 of metal case 14.

### Citation List

### Patent Literature

PTL 1: Unexamined Japanese Patent Publication No. 2003 -270013

### SUMMARY OF THE INVENTION

However, in the conventional configuration, since an electrode of piezoelectric body 16 and metal case 14 are bonded with non-conductive adhesive 17, electrical continuity becomes unstable, and thus characteristics of an ultrasonic transceiver become unstable. Still more, since the electrode of piezoelectric body 16 and metal case 14 are in direct contact with each other to secure electrical continuity, a thickness of an adhesive layer formed of adhesive 17 between the electrode and metal case 14 becomes nonuniform due to an uneven electrode surface of piezoelectric body 16. This results in a disadvantage that characteristics of ultrasonic transceiver 20 become unstable.

Further, when a conductive adhesive in which adhesive resin is mixed with conductive filler is used as an adhesive, electrical continuity can be secured but a proportion of the adhesive resin in the adhesive layer will reduce by the conductive filler. This results in a disadvantage that an adhesive strength for ensuring performance cannot be obtained.

The present disclosure provides a highly-reliable ultrasonic transceiver that is capable of achieving stable electrical continuity between an electrode of a piezoelectric body and a conductive case and has a stable thickness of an adhesive layer formed of an adhesive member provided between the piezoelectric body and the case.

The ultrasonic transceiver of the present disclosure includes a case having conductivity, a piezoelectric body having a piezoelectric electrode, and an adhesive member that bonds the case to the piezoelectric body. The adhesive member includes an adhesive and conductive particles, and secures electrical continuity between the case and the piezoelectric electrode. An adhesive layer formed of the adhesive member provided between the case and the piezoelectric electrode has a thickness equal to or less than a particle diameter of the conductive particles.

With this configuration, electrical continuity can be secured even when a proportion of the conductive particles in the adhesive layer is small, and a predetermined adhesive strength can be secured by increasing a proportion of the adhesive. In addition, since the conductive particles serve as spacers, the thickness of the adhesive layer can be set to a constant thickness to stabilize characteristics of the ultrasonic transceiver.

The ultrasonic transceiver according to the present disclosure can stabilize electrical continuity between the piezoelectric electrode and the conductive case, stabilize the thickness of the adhesive layer formed of the adhesive member provided between the piezoelectric body and the case, and ensure reliability.

### BRIEF DESCRIPTION OF DRAWINGS

FIG. 1A is a cross-sectional view of an ultrasonic transceiver according to an exemplary embodiment.
FIG. 1B is an enlarged schematic view of portion C in FIG. 1A.
FIG. 2 is a cross-sectional view of a conventional ultrasonic transceiver.

### DESCRIPTION OF EMBODIMENT

Hereinafter, an embodiment of the present disclosure will be described with reference to the drawings. Note that the present disclosure is not limited to the exemplary embodiment.

### (Exemplary embodiment)

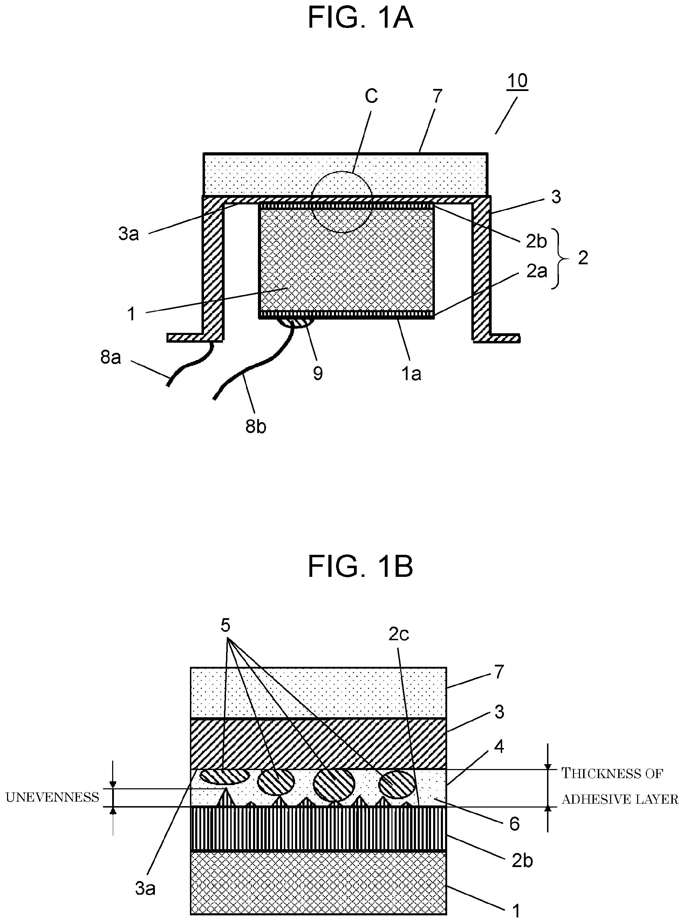

FIG. 1A is a cross-sectional view of an ultrasonic transceiver in an exemplary embodiment. FIG. 1B is an enlarged schematic view of portion C in FIG. 1A.

In FIGS. 1A and 1B, ultrasonic transceiver 10 includes piezoelectric body 1, case 3 having conductivity, and acoustic matching layer 7 bonded to an ultrasonic transmission surface of case 3. Piezoelectric body 1 is bonded to inner surface 3a of case 3 by adhesive member 4.

Adhesive member 4 includes adhesive 6 and conductive particles 5 mixed in adhesive 6, and is formed in a sheet shape. Adhesive 6 is, for example, an epoxy resin-based adhesive, and conductive particles 5 are, for example, resin particles whose surfaces are subjected to Ni-Au plating.

Piezoelectric body 1 includes electrode 2 formed by firing ceramic powder, printing an electrode paste after firing, and then baking the paste. Electrode 2 includes first electrode 2a provided on one of opposing surfaces of piezoelectric body 1, and second electrode 2b provided on the other of the opposing surfaces. For example, first electrode 2a serves as a ground electrode, and second electrode 2b serves as a positive electrode or a negative electrode to apply a drive voltage to piezoelectric body 1.

First electrode 2a is configured to be electrically connected by bonding lead wire 8b by soldering 9. Second electrode 2b is configured to be electrically connected to case 3 via conductive particles 5 mixed in adhesive 6. Further, lead wire 8a is bonded to case 3, and piezoelectric body 1 vibrates by applying a voltage between lead wires 8a and 8b.

Here, examples of selection items of adhesive 6 and conductive particles 5 used for adhesive member 4 are three items, i.e., an adhesive strength of adhesive 6, a particle diameter of conductive particles 5, and an elastic modulus of conductive particles 5.

The adhesive strength is measured by a method of applying a stress to a piezoelectric body in a shear direction after bonding a metal test piece to the piezoelectric body with adhesive and curing the adhesive. The adhesive strength of piezoelectric body 1 and case 3 in the present embodiment is basically 3 N/mm² or more, and an initial value is 5 N/mm² or more.

In addition, by setting a proportion of particle area of conductive particles 5 in adhesive member 4 to 9% or less, a proportion of adhesive 6 in the adhesive layer formed of adhesive member 4 can be sufficiently secured, and the adhesive strength required for ultrasonic transceiver 10 is secured. As a result, for example, even when a repeated thermal shock test is performed at each temperature of 80°C and -40°C every 30 minutes, connection between case 3 and piezoelectric body 1 shows good durability without being damaged.

As schematically shown in FIG. 1B, since surface 2c of second electrode 2b has unevenness of about 30 pm at the maximum, there is a possibility that the electrode and the metal case cannot be bonded due to the unevenness of second electrode 2b in a case of bonding the electrode and the metal case by a conventional non-conductive adhesive. Or, when there is a foreign substance in the adhesive layer formed of adhesive member 4, the electrode and the metal case may not contact. On the other hand, in the present embodiment, the particle diameter of conductive particles 5 is 30 pm or less. As shown in the drawing, although the second electrode is uneven, the conductive particles 5 in the adhesive layer greatly deform at a portion where the unevenness is large, and not deform at a portion where the unevenness is small. As a result, a large number of electrical contacts can be secured to stabilize electrical continuity.

As shown in FIG. 1B, since the surface of second electrode 2b is uneven, the thickness of the adhesive layer formed of the adhesive member becomes nonuniform in the method using the non-conductive adhesive for direct contact, as described in the related art. However, according to the present embodiment, conductive particles 5 are provided in the adhesive layer formed of adhesive member 4. Therefore, even when second electrode 2b is uneven, the conductive particles greatly deform at a portion where the unevenness is large, and do not deform at a portion where the unevenness is small. As a result, even the surface of the electrode is uneven, a thickness of the adhesive layer can be made uniform.

In addition, in the case of the conventional conductive adhesive that ensures conductivity by arranging conductive filler in the adhesive layer formed of the adhesive member, it is necessary to increase the proportion of the conductive filler mixed in the adhesive. As a result, the adhesive strength tends to decrease due to a decreased proportion of resin. However, in the present embodiment, by providing conductive particles 5 having substantially the same size as the thickness of the adhesive layer in the adhesive layer formed of adhesive member 4, it is possible to secure necessary electrical continuity even when the proportion of particle area of conductive particles 5 to adhesive 6 is 9% or less. Therefore, the proportion of the adhesive can be increased as compared with the conventional conductive adhesive. Accordingly, it is possible to secure the adhesive strength required as the ultrasonic transceiver.

In addition, in order to efficiently transmit vibration of piezoelectric body 1 in the ultrasonic transceiver, a thinner adhesive layer formed of adhesive member 4 between piezoelectric body 1 and case 3 achieves better characteristics. This is because the thinner the thickness of the adhesive layer is, the more the vibration of the piezoelectric body can be transmitted without being attenuated. In addition, also when the adhesive layer has a nonuniform thickness, variations in acoustic characteristics increase.

In the present embodiment, since conductive particles 5 included in adhesive member 4 are 30 pm or less, and the conductive particles 5 deform by pressure at the time of bonding, the thickness of the adhesive layer formed of adhesive member 4 between second electrode 2b and case 3 is adjusted to a uniform thickness of 30 pm or less.

Therefore, the thickness of the adhesive layer can be reduced in a state that electrical continuity between the piezoelectric electrode and the metal case is secured. As a result, vibration of piezoelectric body 1 can be efficiently transmitted, and variations in acoustic characteristics can also be reduced.

The present embodiment uses adhesive member 4 formed into a sheet shape after mixing conductive particles 5 in adhesive 6. However, it is needless to say that a paste-like material in which conductive particles 5 are mixed with adhesive 6 may be applied for an appropriate amount.

As described above, a first aspect of the disclosure includes the case having conductivity, the piezoelectric body having the piezoelectric electrode, and the adhesive member that bonds the case to the piezoelectric body. The adhesive member includes the adhesive and the conductive particles, and secures electrical continuity between the case and the piezoelectric electrode. The thickness of the adhesive layer formed of the adhesive member provided between the case and the piezoelectric electrode is equal to or less than the particle diameter of the conductive particles.

With this configuration, electrical continuity can be secured even when the proportion of the conductive particles in the adhesive layer is small, and a predetermined adhesive strength can be secured by increasing the proportion of the adhesive. In addition, the use of the adhesive stabilizes the electrical continuity between the piezoelectric electrode and the case, and the thickness of the adhesive layer between the piezoelectric body and the case. Accordingly, ultrasonic wave transmission/reception characteristics can be stabilized.

According to a second aspect of the disclosure, particularly in the ultrasonic transceiver according to the first aspect of the disclosure, the adhesive strength between the case and the piezoelectric electrode may be a predetermined value or more.

With this configuration, electrical characteristics and adhesion reliability of the piezoelectric body and the case can be secured.

According to a third aspect of the disclosure, particularly in the ultrasonic transceiver according to the first or second aspect of the disclosure, the adhesive layer between the case and the piezoelectric electrode may have a uniform thickness of 30 pm or less.

With this configuration, the characteristics of the ultrasonic transceiver can be stabilized.

According to a fourth aspect of the disclosure, particularly in the ultrasonic transceiver according to any one of the first to third aspects of the disclosure, the conductive particles may have a particle diameter of 30 pm or less.

With this configuration, electrical continuity between the piezoelectric electrode and the case can be secured, and the thickness of the adhesive layer can be made uniform.

According to a fifth aspect of the disclosure, particularly in the ultrasonic transceiver according to any one of the first to fourth aspects of the disclosure, the proportion of the conductive particles to the adhesive may be less than or equal to a predetermined value.

With this configuration, adhesion reliability between the piezoelectric body and the case can be secured.

According to a sixth aspect of the disclosure, particularly in the ultrasonic transceiver according to any one of the first to fifth aspects of the disclosure, the conductive particles may be formed by coating resin particles with a conductive material.

With this configuration, the conductive particles deform at the time of bonding to reduce unevenness of the piezoelectric body, and achieve a uniform thickness of the adhesive layer between the piezoelectric body and the case.

### INDUSTRIAL APPLICABILITY

As described above, the ultrasonic transceiver according to the present disclosure includes the piezoelectric body and the conductive case that are electrically connected. The present disclosure can stabilize the electrical continuity between the piezoelectric electrode and the case, stabilize the thickness of the adhesive layer formed of the adhesive member provided between the piezoelectric body and the case, and secure reliability. Thus, the present disclosure can also be applied to applications, such as sensing devices for automotive.

### REFERENCE MARKS IN THE DRAWINGS

- 1: piezoelectric body
- 2: electrode (piezoelectric electrode)
- 2a: first electrode (piezoelectric electrode)
- 2b: second electrode (piezoelectric electrode)
- 3: case
- 4: adhesive member
- 5: conductive particles
- 6: adhesive

## Claims

1. An ultrasonic transceiver comprising: a case having conductivity; a piezoelectric body having a piezoelectric electrode; and an adhesive member that bonds the case to the piezoelectric body, wherein
the adhesive member includes an adhesive and a conductive particle and secures electrical continuity between the case and the piezoelectric electrode, and an adhesive layer formed of the adhesive member provided between the case and the piezoelectric electrode has a thickness equal to or less than a particle diameter of the conductive particle.

2. The ultrasonic transceiver according to claim 1, wherein an adhesive strength between the case and the piezoelectric electrode is equal to or more than a predetermined value.

3. The ultrasonic transceiver according to claim 1 or 2, wherein the adhesive layer between the case and the piezoelectric electrode has a uniform thickness equal to or less than 30 µm.

4. The ultrasonic transceiver according to any one of claims 1 to 3, wherein the conductive particle has the particle diameter equal to or less than 30 pm.

5. The ultrasonic transceiver according to any one of claims 1 to 4, wherein a proportion of the conductive particle to the adhesive is equal to or less than a predetermined value.

6. The ultrasonic transceiver according to any one of claims 1 to 5, wherein the conductive particle is formed by coating a resin particle with a conductive material.
